# FASCICULE DE BREVET EUROPEEN

(11) **EP 2 302 666 B1**
(45) Date de publication et mention de la délivrance du brevet: **01.11.2017**
(21) Numéro de dépôt: 10176997.4
(22) Date de dépôt: 16.09.2010
(51) Int. Cl.: H01L 21/02, H01L 21/762

(54) **Procédé de planarisation par ultrasons d'un substrat dont une surface a été libérée par fracture d'une couche enterrée fragilisée**
Verfahren zur Planarisierung durch Ultraschall eines Substrates dessen Oberfläche durch Bruch einer geschwächten vergrabenen Schicht freigegeben wurde
Process of planarisation by ultrasounds of a substrate whose surface was released by fracture of a weakened buried layer

(30) Priorité: 25.09.2009 FR 0956661
(43) Date de publication de la demande: 30.03.2011
(73) Titulaire: Commissariat à l'Énergie Atomique et aux Énergies Alternatives, 75015 Paris (FR)
(72) Inventeur: Tauzin, Aurélie, 38120, SAINT EGREVE (FR)
(74) Mandataire: Colombo, Michel

(56) Documents cités:
- EP-A1- 1 427 002
- EP-A2- 1 662 560
- US-A- 5 837 662
- US-A1- 2001 055 854
- US-A1- 2007 249 139

## Description

### Domaine de l'invention

L'invention concerne, dans le domaine des micro-technologies ou nano-technologies, le traitement d'une surface d'un substrat mise à nu par fracture le long d'une couche préalablement fragilisée en vue d'en améliorer la planéité, notamment par détachement d'éventuels résidus de matière résultant de défauts locaux de fracture.

Elle vise notamment le cas de la préparation d'une face d'un substrat donneur, mise à nu lors d'un cycle de formation d'une couche mince par implantation ionique puis fracture, en vue d'un nouveau cycle de formation d'une nouvelle couche mince.

Il est rappelé que les substrats utilisés en micro-technologie (ou nano-technologie) sont typiquement constitués de silicium, éventuellement allié à du germanium, ou d'alliages de matériaux des colonnes III-V ou II-VI du Tableau Périodique des éléments.

### Etat de la technique et situation de la problématique

La formation de couches minces à partir d'un substrat donneur est une étape classique en micro-technologie. Parmi les techniques principales pour une telle formation, on peut citer le procédé connu sous le nom de « Smart Cut™».

Le procédé « Smart Cut™ » permet le détachement d'un film mince et son transfert sur un raidisseur par les étapes suivantes :
- 1. bombardement d'une face d'un substrat donneur avec des espèces gazeuses (H ou gaz rares) afin d'implanter ces ions en concentration suffisante pour provoquer la création d'une couche enterrée fragilisée par la présence de microcavités,
- 2. mise en contact intime de cette face du substrat avec un raidisseur et
- 3. fracture au niveau de la couche de microcavités, par l'application d'un traitement thermique et/ou d'une contrainte de détachement (par exemple, l'insertion d'une lame entre les deux substrats et/ou encore des efforts de traction et/ou de flexion et/ou de cisaillement, et/ou encore l'application d'ultrasons ou de micro-ondes de puissance et de fréquence judicieusement choisies).

De manière habituelle, pour former plusieurs couches minces à partir d'un tel substrat donneur, on recycle le reliquat du substrat obtenu à la fin d'un cycle en utilisant ce reliquat comme substrat donneur pour un nouveau cycle des étapes 1-3 ci-dessus. On assure ainsi, à partir d'un même substrat donneur, plusieurs transferts de couches minces sur des raidisseurs différents.

En pratique, l'épaisseur de la couche mince (on parle parfois de film mince) est tellement faible, typiquement inférieure à quelques microns, que son détachement vis-à-vis du substrat donneur s'apparente à un pelage.

En fait, la présence d'un raidisseur n'est pas toujours requise ; en particulier, un raidisseur peut être omis lorsque l'épaisseur de la couche mince est suffisante pour que celle-ci soit auto-porteuse. En d'autres termes, la présence d'un raidisseur sert principalement à faciliter la manipulation d'une couche mince qui vient d'être détachée d'un substrat donneur.

Toutefois, avec la tendance à réduire constamment l'épaisseur des couches minces, la présence d'un substrat porteur (servant de raidisseur ou de manipulateur) est de plus en plus souhaitable.

On comprend que le recyclage du reliquat obtenu par l'application d'un cycle précité à un substrat donneur ne peut être effectué que sous réserve que la surface de la face libérée lors du cycle précédent a une qualité suffisante pour permettre sa fixation à un nouveau substrat porteur.

Mais diverses raisons font que, le plus souvent, l'étape de fracture le long de la couche enterrée fragilisée entraîne le détachement d'une partie seulement du film mince ; en effet, le film reste localement solidaire du substrat donneur au niveau de zones appelées zones non transférées, formant ainsi des marches d'épaisseur variant entre 10 à 1000nm (généralement sensiblement égale à l'épaisseur du film mince). Le recyclage du substrat donneur nécessite alors des étapes particulières de planarisation par polissage mécanique et/ou attaque chimique.

L'existence de telles zones non transférées provient de ce que, idéalement, l"étape 2 de mise en contact intime du substrat donneur (préalablement implanté) avec le raidisseur doit être réalisée sur des surfaces planes et parfaitement propres. Le problème est que, lors de sa mise en oeuvre, cette mise en contact intime peut ne pas être réalisée sur toute la surface des substrats :
- tout d'abord, les substrats donneurs (ainsi que les substrats porteurs formant raidisseurs) sont typiquement des plaques dont les bords sont chanfreinés ; ces plaques ne peuvent donc pas être mises en contact en leur périphérie. On rencontre ce problème de non collage en bord de plaques pour tous les matériaux utilisés en micro-technologie (Si, Ge, GaAs, GaN, Saphir, SiGe, LiTaO₃, LiNbO₃, SiC, InP, etc.) et pour tous les diamètres de plaques (typiquement de 5cm à 30 cm, soit de 2 à 12 pouces),
- en outre, dans le cas de substrats ou de couches structurés volontairement (par exemple par des motifs en creux/reliefs réalisés par photo-lithogravure) ou involontairement (par exemple par des défauts de croissance dans le cas de couches épitaxiées, ou encore par des défauts liés au dépôt d'une couche sur le substrat initial), les motifs ou défauts « en creux » sur la surface donnent lieu localement à des zones non collées (ZNC en abrégé),
- enfin, dans le cas d'un nettoyage peu efficace, la présence de particules à l'interface de collage donne également lieu à des zones non collées.

Lors de l'étape de fracture, lorsque la dimension des ZNC est grande par rapport à l'épaisseur du film à transférer (par exemple ratio [dimension latérale ZNC] / [épaisseur film] de l'ordre de 10), le film mince reste localement solidaire du substrat initialement implanté. On parle alors de zones non transférées (ZNT en abrégé).

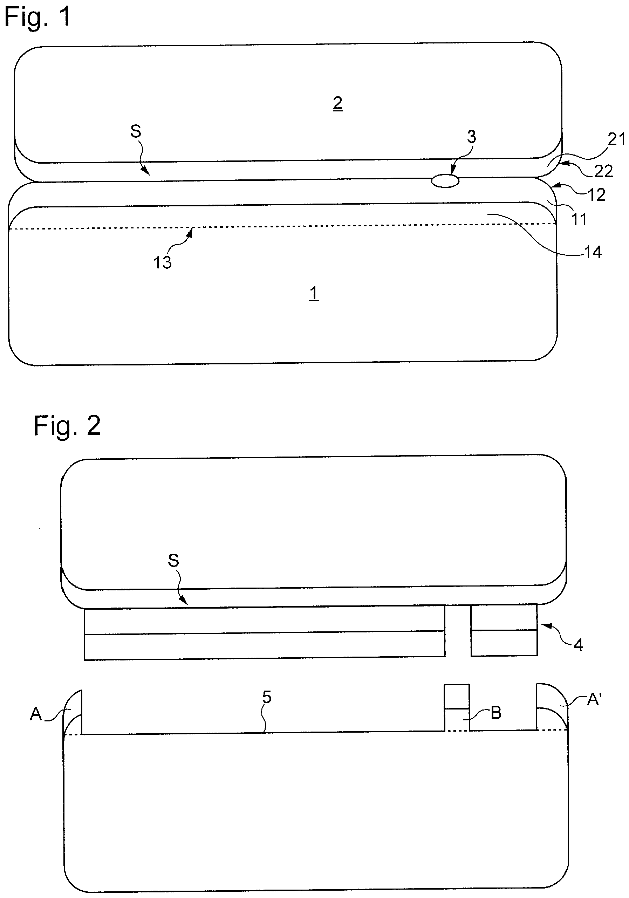

La figure 1 représente de manière schématique un substrat donneur 1 qui est rapportée par collage moléculaire à un substrat porteur 2.

Le collage des deux substrats 1 et 2 est ici réalisé par l'intermédiaire de couches de collage 11 et 21 formées sur les faces libres des deux substrats.

Ces deux substrats (ici des plaques ou « wafers » en anglais) sont chanfreinés en leurs périphéries notées 12 et 22. En outre, en conséquence d'un nettoyage qui n'a pas été complètement efficace, une particule 3 est piégée dans l'interface S entre les couches de collage, de sorte que, à l'emplacement de cette particule, les deux substrats ne sont pas collés l'un à l'autre (bien entendu, en fonction des matériaux choisis pour les deux substrats il est possible d'omettre les couches de collage) ; dans l'exemple considéré, les deux substrats sont en silicium et les couches de collage sont en oxyde de silicium (il peut s'agir de la couche d'oxyde thermique naturellement présente à la surface du substrat, mais il peut aussi s'agir d'une couche plus épaisse formée volontairement).

Le substrat donneur a été préalablement fragilisé, par implantation d'espèces gazeuses, au niveau d'une couche 13, enterrée à une profondeur sous la surface participant à l'interface qui détermine l'épaisseur de la future couche mince que l'on souhaite transférer depuis le substrat donneur vers le substrat porteur; la référence 14 désigne la couche située entre la couche enterrée et l'interface de collage, dont le détachement donnera la couche mince.

La figure 2 schématise le fait que, du fait de l'absence de collage aux bords des substrats (puisqu'ils sont chanfreinés) ainsi qu'à l'emplacement de la particule, la couche 14 ne s'est pas détachée partout du substrat donneur 1 : il subsiste des portions de bord A et A' et un îlot B correspondant à l'emplacement de la particule. Bien entendu, sur ces figures 1 et 2, l'épaisseur de la couche 14 est très exagérée par rapport aux dimensions des particules ou des bords chanfreinés.

En pratique, ces zones non collées aboutissent à des soulèvements voire des détachements très locaux (sur des dimensions de quelques µm²) de la couche mince, sous forme de cloques ou de zones exfoliées.

Les dimensions des zones non transférées dépendent non seulement des dimensions des zones non collées mais aussi de la force de collage (cette force dépend notamment de la propreté des surfaces mises en contact, mais aussi des conditions de mise en oeuvre d'un éventuel traitement thermique pendant ou après l'implantation).

La figure 2 fait clairement comprendre la nécessité pour un recyclage de prévoir un traitement de la surface du substrat qui a été libérée par le détachement de la couche 14 pour donner la couche mince 4, ce traitement visant à planariser cette surface pour en éliminer les marches formées par les zones non transférées.

Des exemples d'étapes de planarisation sont notamment décrits dans les documents EP1427002 et EP1427001 à propos de la périphérie des substrats où subsiste un col constitué de la partie périphérique de la couche devant former la couche mince. Il est ainsi préconisé, notamment, d'appliquer un traitement de planarisation, localisé à la périphérie, comprenant un polissage, ou l'application d'une pression mécanique, ou une attaque chimique sélective ou une attaque ionique (par exemple par faisceau ionique). En variante, il est préconisé de séparer le col, par projection d'un jet de fluide sur ce col, par exemple depuis l'intérieur de ce col, ou par projection d'un faisceau laser sur ce col, de préférence parallèlement à la surface mise à nu, ou par application d'une onde de choc sur la face arrière du substrat. Ce traitement localisé à la périphérie peut être suivi d'un traitement de planarisation appliqué à l'ensemble de la surface.

On comprend toutefois que de tels traitements localisés peuvent être complexes à mettre en oeuvre. De l'état de la technique est également connu de : US2001/0055854 A1, US5837662, EP1662560A2, US2007/0249139A1.

### Objet et solution générale de l'invention

L'invention a pour objet un procédé de planarisation de surfaces mises à nu par fracture de couches fragilisées au sein d'un substrat donneur, avec éventuelle formation de marches subsistant sur ces surfaces, qui soit simple de mise en oeuvre, sans nécessiter de traitement localisé et pouvant au contraire, lorsque cela est utile, être mis en oeuvre sur une pluralité de tels substrats à la fois.

L'invention propose à cet effet un procédé de planarisation d'un substrat micro-technologique ayant une face libérée par fracture le long d'une couche fragilisée, selon lequel on met cette face en présence d'un bain et on y applique des ultrasons à une fréquence comprise entre 10kHz et 80kHz dans des conditions propres à provoquer de la cavitation le long de ladite face.

En pratique, pour la plupart des matériaux couramment utilisés en micro-technologie (la miniaturisation conduit même à parler de nano-technologies), les conditions d'application des ultrasons respectent par ailleurs avantageusement les conditions suivantes :
- puissance des ultrasons/volume du bain >5 W/L
- puissance >10 W
- durée > 1 min
- température comprise entre 1 °C et 100°C

On comprend aisément que la durée de traitement peut être d'autant plus réduite que la puissance est élevée Il existe par ailleurs une température optimale, telle que la viscosité du liquide utilisé dans le bain ultrasons soit minimale tout en évitant l'ébullition (pour l'eau, cette température est comprise entre 40 et 60°C).

Le fluide conducteur des ultrasons est préférablement choisi en sorte d'avoir une faible viscosité, de manière à favoriser le décapage de la surface par cavitation. Ainsi on utilisera avantageusement de l'eau. Le fluide peut aussi être constitué d'une solution gravant préférentiellement le matériau constituant la surface mise à nu et présentant l'endommagement à lisser (un tel fluide peut être du type Secco, Wright).

Il faut noter que le fait de choisir de l'eau comme fluide pour le bain de cavitation revient à choisir un fluide de cavitation qui, contrairement à ce qui est réalisé le plus souvent dans les bains de cavitation classiques, n'ajoutent aucun effet chimique ou électrostatique à l'effet de la cavitation proprement dite.

En fait, on connaissait déjà la mise en oeuvre d'un nettoyage de certaines surfaces par des ultrasons, mais on savait aussi que le phénomène de cavitation qui intervient dans un tel nettoyage par ultrasons peut, dans certaines conditions, induire un endommagement de la surface, ce qui avait pour conséquence que l'endommagement par cavitation était un effet néfaste que les utilisateurs d'ultrasons cherchaient à éviter comme étant néfaste (voir par exemple l'article « Effect of roughness and wettability of silicon wafer in cavitation erosion » de Jiang, Liu & Chen, paru dans Chinese Science Bulletin/ September 2008/vol 53/n°18/pp2879-2885).

Toutefois, pour l'application visée par la présente invention, il a été observé de manière surprenante que les ultrasons, dans certaines conditions, permettent l'élimination des zones non transférées (ZNT) résiduelles pouvant exister après un traitement de fracture d'une couche enterrée fragilisée (résultant par exemple du procédé « Smart Cut™ »), sans détériorer le reste de la surface. Bien que l'effet de la cavitation dus à des ultrasons soit généralement considéré comme dirigé vers la surface, il semble que cet effet puisse se faire aussi le long de celle-ci en sorte de détacher des ZNT, avant même que se produise un endommagement sensible de la surface elle-même. Ce phénomène peut être du à une cavitation plus importante sur les aspérités de surface (ZNT) : ainsi il a été observé que plus la surface est rugueuse, plus il existe de sites de nucléation pour les bulles de cavitation, et donc plus l'effet des ultra-sons est important.

En complément du fait que l'homme du métier était ainsi dissuadé de mettre en oeuvre une cavitation, il faut noter que, bien qu'une telle cavitation puisse être analysée comme impliquant la formation d'une multitude d'ondes de choc (voir ci-dessous) au fur et à mesure qu'éclatent des bulles sous pression, il s'agit d'un phénomène foncièrement différent de l'application d'une (ou plusieurs) onde(s) de choc appliquée(s) sur la face arrière d'un substrat ainsi que le mentionne le document EP - 1 427 002 précité (apparemment en dehors de tout bain) pour décoller une couronne résiduelle de matière ; on comprend en effet que la multitude des ondes de choc générées de manière désordonnée par la cavitation au plus près de la surface à planariser, tout au long de celle-ci, a des effets bien différents de ceux d'une onde de choc macroscopique appliquée de manière contrôlée à l'ensemble du substrat, par une face opposée à la face d'intérêt.

Une des particularités de l'invention a consisté à reconnaître qu'il y avait des conditions dans lesquelles une telle cavitation pouvait être mise à profit, contrairement aux préjugés de l'homme de métier, pour traiter utilement l'ensemble d'une surface mise à nu par fracture.

Ce procédé permet le recyclage du substrat donneur directement après fracture/cavitation, ou après un traitement de surface simplifié tel qu'un simple polissage mécano-chimique réalisé après la cavitation.

Le substrat donneur ainsi traité peut ensuite faire l'objet de divers traitements, de formation de composants micro-technologiques (composants ou capteurs micro-électroniques ou micro-mécaniques ou micro-optiques, etc.). Toutefois, l'invention s'applique tout particulièrement bien au cas où le substrat donneur fait l'objet d'autres cycles de fracture le long de couches enterrées fragilisées, notamment suivant la technologie « Smart Cut™ ».

C'est ainsi que l'invention propose en particulier un procédé conforme à la revendication 1.

Comme précédemment, les ultrasons sont de préférence appliqués dans les conditions suivantes ;
- puissance ultrasons/volume de bain > 5W/l
- puissance > 10W,
- durée > 1 min,
- température comprise entre 1°C et 100°C.

Selon d'autres caractéristiques avantageuses de l'invention, éventuellement combinées :
- la fréquence des ultrasons est choisie entre 10 kHz et 40 kHz avec une puissance comprise entre 5W/L et 60W/L (par exemple supérieure à 20 W/L),
- la durée du traitement par ultrasons est comprise entre 1 minute et 20 h (par exemple supérieure à 1 h),
- on forme la couche enterrée fragilisée par implantation d'ions hydrogène, à une dose comprise entre 10¹⁶ ions.cm⁻² et 5.10¹⁷ ions.cm⁻²,
- le fluide du bain est de l'eau (ou est essentiellement formé d'eau),
- le fluide du bain est un mélange d'eau et d'acétone (la quantité d'acétone peut être suffisamment faible pour qu'on puisse considérer que le bain est essentiellement formé d'eau),
- la température du bain est comprise entre 40°C et 60°C,
- l'étape de mise en présence d'un bain dans lequel on applique des ultrasons dans des conditions propres à provoquer de la cavitation le long de ladite face est réalisée sans traitement intermédiaire de surface après l'étape de fracture ; c'est donc la surface mise à nu qui est soumise aux ultrasons exactement dans l'état résultant de la fracture,
- on procède à un recyclage du substrat donneur sans traitement intermédiaire après l'étape de mise en présence d'un bain dans lequel on applique lesdits ultrasons ; c'est une version particulièrement simple de l'invention ; toutefois, un traitement de surface simplifié, tel qu'un simple polissage mécano-chimique peut être envisagé entre l'application des ultrasons et le démarrage d'un nouveau cycle,
- l'étape de mise en présence d'un bain dans lequel on applique des ultrasons dans des conditions propres à provoquer de la cavitation est appliquée collectivement aux faces respectives de plusieurs substrats mises à nu par une telle étape de fracture.,

L'invention s'applique tout particulièrement bien à des substrats donneurs en silicium (ou formés de silicium dans sa partie destinée à former la surface à planariser).

### Description d'au moins un exemple de mise en oeuvre

Des objets, caractéristiques et avantages de l'invention ressortent de la description qui suit, donnée à titre d'exemple illustratif non limitatif, donnée en regard des dessins annexés sur lesquels :
- la figure 1 est une vue schématique d'un substrat donneur collé à un substrat porteur après formation d'une couche enterrée fragilisée,
- la figure 2 est une vue schématique de cet assemblage après fracture le long de la couche enterrée fragilisée,
- la figure 3 est une vue schématique du traitement de planarisation de l'invention, et
- la figure 4 est une vue schématique du reliquat du substrat donneur à la fin de l'étape de la figure 3 au cours d'un nouveau cycle de transfert d'une couche de ce substrat donneur.

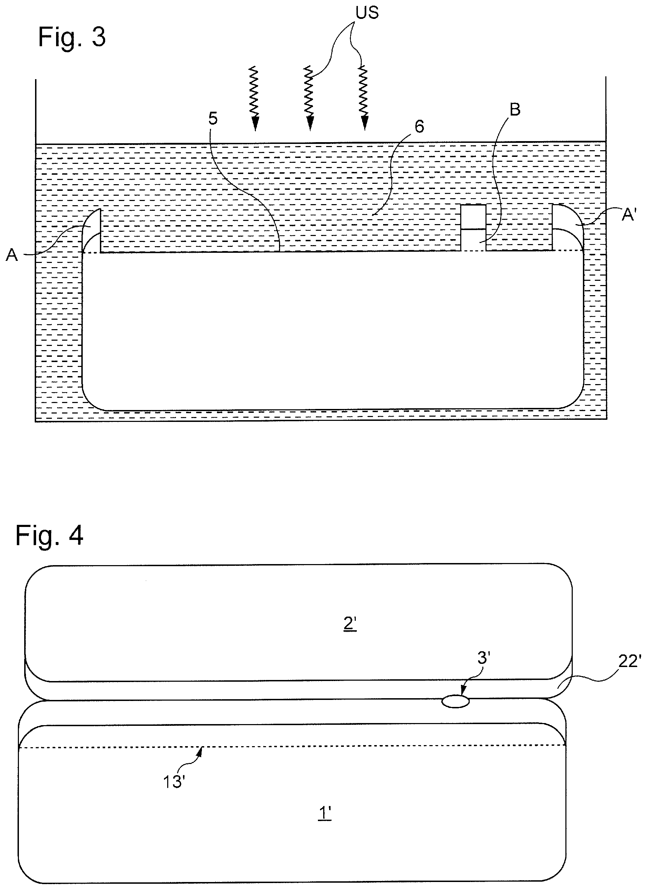

L'invention propose un procédé de planarisation d'une surface mise à nu par fracture d'une couche enterrée fragilisée, notamment pour le recyclage d'un substrat après transfert de couches par la technologie « Smart Cut™ », basé sur l'application d'ultrasons judicieusement choisis en fonction des matériaux en présence en sorte de provoquer de l'endommagement par cavitation, qui soit tout particulièrement localisé sur les résidus à éliminer, sans pour autant générer un endommagement sensible du reste de la surface mise à nu, notamment grâce à une fréquence comprise entre 10kHz et 80kHz. La mise en oeuvre de cette étape de planarisation est schématisée à la figure 3, avec la mise en contact de la surface 5 mise à nu, endommagée par la fracture le long de la couche enterrée 3 (conformément aux figures 1 et 2, de manière connue en soi), avec un bain 6 dans lequel sont générés des ultrasons désignés sous la référence US.

A titre d'exemple, on forme la couche enterrée fragilisée par implantation d'hydrogène, à une dose comprise entre 10¹⁶ ions.cm⁻² et 5.10¹⁷ ions.cm⁻².

Notamment dans le cas où le matériau formant le substrat en dessous de la surface 5 est en silicium (ce qui correspond à un cas de grande importance pratique), les ultrasons appliqués respectent avantageusement les conditions suivantes :
- puissance ultrasons/volume du bain >5 W/L (de préférence au moins égale à 20 W/L voire à 30 W/L ; de préférence au plus égale à 60 W/L),
- puissance >10 W
- durée > 1 min (de préférence au moins égale à 1 h),
- température comprise entre 1°C et 100°C, par exemple à la température ambiante ou entre 40° et 60°C.

Le fluide conducteur des ultrasons est préférablement à faible viscosité, de manière à favoriser le décapage de la surface par cavitation. Ainsi on utilisera avantageusement de l'eau, voire de l'eau additionnée d'acétone pour en réduire la viscosité (de préférence dans une quantité telle que le fluide du bain peut être considéré comme formé essentiellement d'eau). Le fluide peut aussi être constitué d'une solution gravant préférentiellement le Si endommagé (type Secco, Wright).

Il est rappelé que le mécanisme de nettoyage (de même que le mécanisme d'endommagement) par ultrasons est fondé sur un effet de cavitation, avec la création et l'implosion de bulles formées lorsqu'un liquide est soumis à une onde de pression périodique. Plus précisément :
- des bulles de vapeur se forment à faible pression,
- du fait de la forte pression dans le liquide entourant la bulle, celle-ci tend à se contracter, en augmentant sa pression et sa température internes,
- lorsqu'une taille critique est atteinte, un mécanisme d'implosion très violent se produit, qui provoque une onde de choc acoustique (la température interne peut atteindre plusieurs milliers de degrés K, la pression peut atteindre plusieurs centaines d'atmosphères et cela peut se traduire par la formation de jets dont la vitesse peut atteindre quelques 400km/h,
- cette implosion des bulles de cavitation le long d'une surface solide provoque un nettoyage, voire un décapage, ou même une rupture locale par fatigue, d'où un détachement local et éventuellement une exfoliation du matériau.

On comprend que la cavitation soit considérée comme néfaste du fait de l'endommagement qu'elle provoque et qu'il y ait de fortes réticences de la part de l'homme de métier à mettre en oeuvre des ultrasons sur une surface dont l'état de surface doit avoir une rugosité aussi faible que possible.

Toutefois, il a été observé de manière surprenante que les ultrasons, dans certaines conditions choisies en fonction de la nature des substrats, permettent l'élimination des ZNT résiduelles pouvant résulter d'un procédé de transfert de couches tel que le procédé « Smart Cut™ », sans détériorer le reste de la surface.

L'étape de mise en présence de la face mise à nu en présence d'un bain où on génère de la cavitation a de préférence lieu sans la moindre étape intermédiaire de traitement de surface après la fracture, même légère ; cette cavitation est en effet avantageusement réalisée sur la surface mise à nu dans l'état même qui résulte de la fracture.

On obtient ainsi, avec le reliquat du substrat 1 dont la couche 14 a été détachée, un nouveau substrat donneur 1' auquel on peut appliquer (cf. la figure 4) les mêmes étapes qu'aux figures 1 et 2, avec la formation d'une couche enterrée fragilisée, le collage à un substrat porteur, et le détachement par fracture d'une nouvelle couche 14'.

De manière avantageuse, on procède à un recyclage du substrat donneur sans traitement intermédiaire après l'étape de mise en présence d'un bain dans lequel on applique lesdits ultrasons.

De manière également avantageuse, l'étape de mise en présence d'un bain dans lequel on applique des ultrasons dans des conditions propres à provoquer de la cavitation est appliquée collectivement aux faces respectives de plusieurs substrats mises à nu par une telle étape de fracture.

Ce procédé de recyclage présente de nombreux avantages :
- il permet un nettoyage de pièces pouvant avoir une grande variété de tailles et de géométries,
- les particules détachées sont naturellement dispersées et ne risquent pas de se redéposer sur la surface,
- cette planarisation par ultrasons est un procédé de nettoyage plus rapide que les procédés classiques,
- lorsqu'il est choisi d'utiliser un solvant, celui-ci peut être utilisé de manière bien moins concentrée que lorsque ce solvant est utilisé pour une planarisation classique,
- le traitement par ultrasons permet un contrôle électronique et donc une automatisation, d'où une stabilité et une reproductibilité améliorées par rapport aux procédés connus.
- Le traitement des substrats peut être réalisé collectivement et à faible coût, ce qui est particulièrement intéressant pour son industrialisation notamment pour des applications photovoltaïques,...

### Exemple 1 :

Dans un premier exemple, un substrat Si recouvert d'un oxyde SiO₂ d'épaisseur 400nm est implanté avec des ions H⁺ dans les conditions suivantes :
énergie = 76keV,
dose = 6.10¹⁶ ions.cm⁻².

Le substrat Si est ensuite collé par adhésion moléculaire sur un raidisseur Si. La fracture est ensuite provoquée au niveau de la couche implantée par un traitement thermique à 450°C pendant 1 h. Une partie du film de Si implanté est transférée sur le substrat Si raidisseur, on obtient ainsi une structure SOI (Silicon On Insulator) qui peut être utilisée par exemple pour la réalisation de composants microélectroniques. Une autre partie localisée sur la couronne du substrat Si reste solidaire du substrat implanté, et présente des déformations de surface de type cloques.

L'application, à la surface du substrat donneur mise à nu par la fracture, d'ultrasons 20kHz, à une puissance de 30W/L pendant 16h dans de l'eau permet d'éliminer ces cloques résiduelles et donc de supprimer les fortes marches existant sur le substrat pelé (marches de hauteur 760 nm correspondant au film transféré). Un léger polissage peut alors être appliqué pour diminuer la rugosité de fracture observée après transfert. Le substrat est alors prêt pour un nouveau cycle.

### Exemple 2 :

Dans un deuxième exemple, un substrat GaN (⁷⁰Ga ¹⁴N) cristallin est recouvert d'une couche de collage SiO₂ d'épaisseur 500nm, déposée par LPCVD (Low Pressure Chemical Vapor Deposition) à 900°C. Ce substrat est implanté avec des ions H⁺ dans les conditions suivantes :
énergie = 90keV,
dose = 4^{E}17 ions.cm⁻².

Le substrat GaN avec la couche de collage est ensuite collé par adhésion moléculaire sur un substrat saphir. La fracture est ensuite provoquée au niveau de la couche implantée par un traitement thermique à 220°C. L'étape de fracture 220°C entraîne le détachement d'un film de GaN d'épaisseur d'environ 480nm et de la couche de collage SiO₂ de 500nm sur la majorité de la surface du substrat GaN implanté. Une partie du film de GaN est transférée sur le substrat saphir, on obtient ainsi une structure GaN/SiO₂/Saphir qui peut être utilisée par exemple pour la réalisation de LED. Une autre partie localisée sur la couronne du substrat GaN reste solidaire du substrat sous forme de cloques. Le substrat GaN initialement implanté peut alors être recyclé, sans le moindre traitement de surface après la fracture, pour d'autres transferts, après une étape d'ultrasons suivante : 40kHz à une puissance volumique de 60W/L pendant 1 h dans un mélange eau / acétone (l'acétone a pour intérêt de permettre de diminuer la viscosité et donc favoriser la cavitation).

Un simple resurfaçage par CMP (par exemple, quelques secondes de polissage) peut éventuellement être appliqué afin d'éliminer la rugosité liée à la fracture avant un nouveau cycle.

## Revendications

1. Procédé de formation d'une pluralité de couches minces à partir d'un substrat donneur micro-technologique, selon lequel on applique des cycles comportant les étapes suivantes :
* on forme par implantation ionique une couche enterrée fragilisée sous une face libre de ce substrat donneur, l'épaisseur de matière comprise entre cette face libre définissant l'épaisseur d'une future couche mince,
* on met ce substrat donneur en contact intime avec un substrat porteur par collage moléculaire entre cette face libre du substrat donneur à une face libre de ce substrat porteur,
* on provoque une fracture le long de cette couche enterrée fragilisée en sorte de libérer ladite couche mince vis-à-vis d'un reliquat du substrat donneur, en mettant à nu des faces respectives de cette couche mince et de ce reliquat,
* on applique un traitement à ladite face mise à nu du reliquat du substrat donneur en vue d'un nouveau cycle pour lequel ce reliquat constitue le substrat donneur, ledit traitement de ladite face mise à nu comportant la planarisation de cette face mise à nu en la mettant en présence d'un bain dans lequel on applique des ultrasons à une fréquence comprise entre 10kHz et 80kHz dans des conditions propres à provoquer de la cavitation le long de ladite face qui élimine des zones non transférées résiduelles qui existent après la fracture sans détériorer le reste de la face mise à nu.

2. Procédé selon la revendication 1, **caractérisé en ce que** l'on forme la couche enterrée fragilisée par implantation d'ions hydrogène, à une dose comprise entre 10¹⁶ ions.cm⁻² et 5.10¹⁷ ions.cm⁻².

3. Procédé selon la revendication 1 ou la revendication 2, **caractérisé en ce que** les ultrasons sont appliqués dans les conditions suivantes :
- puissance ultrasons/volume du bain >5 W/L
- puissance >10 W
- durée > 1 min
- température comprise entre 1°C et 100°C

4. Procédé selon l'une quelconque des revendications 1 à 3, **caractérisé en ce que** le bain est essentiellement formé d'eau.

5. Procédé selon l'une quelconque des revendications 1 à 4, **caractérisé en ce que** le fluide du bain est un mélange d'eau et d'acétone.

6. Procédé selon l'une quelconque des revendications 1 à 5, **caractérisé en ce que** la fréquence des ultrasons est choisie entre 10 kHz et 40 kHz avec une puissance comprise entre 5W/L et 60W/L, et la durée du traitement par ultrasons est comprise entre 1 mn et 20 h.

7. Procédé selon l'une quelconque des revendications 1 à 6, **caractérisé en ce que** l'étape de mise en présence d'un bain dans lequel on applique des ultrasons dans des conditions propres à provoquer de la cavitation le long de ladite face est réalisée sans traitement intermédiaire de surface après l'étape de fracture.

8. Procédé selon l'une quelconque des revendications 1 à 7, **caractérisé en ce qu'**on procède à un recyclage du substrat donneur sans traitement intermédiaire après l'étape de mise en présence d'un bain dans lequel on applique lesdits ultrasons.

9. Procédé selon l'une quelconque des revendications 1 à 8, **caractérisé en ce que** l'étape de mise en présence d'un bain dans lequel on applique des ultrasons dans des conditions propres à provoquer de la cavitation est appliquée collectivement aux faces respectives de plusieurs substrats mises à nu par une telle étape de fracture.

10. Procédé selon l'une quelconque des revendications 1 à 9, **caractérisé en ce que** le substrat donneur est en silicium.

## Patentansprüche

1. Verfahren zur Bildung einer Vielzahl dünner Schichten, ausgehend von einem mikrotechnologischen Donorsubstrat, nach dem Zyklen mit den folgenden Schritten angewandt werden:
* durch Ionenimplantation wird eine geschwächte vergrabene Schicht unter einer freien Fläche dieses Donorsubstrates gebildet, wobei die Materialdicke zwischen dieser freien Fläche die Dicke einer zukünftigen dünnen Schicht definiert,
* dieses Donorsubstrat wird durch molekulares Kleben zwischen dieser freien Fläche des Donorsubstrates und einer freien Fläche eines Trägersubstrates in engen Kontakt mit diesem Trägersubstrat gebracht,
* längs dieser geschwächten vergrabenen Schicht wird ein Bruch hervorgerufen, so dass die dünne Schicht von einem Restbestand des Donorsubstrates gelöst wird, wobei die jeweiligen Flächen dieser dünnen Schicht und dieses Restbestands freigelegt werden,
* auf diese freigelegte Schicht des Restbestand des Donorsubstrates wird im Hinblick auf einen neuen Zyklus, für den dieser Restbestand das Donorsubstrat bildet, eine Bearbeitung angewandt;
wobei die Bearbeitung der freigelegten Fläche die Planarisierung dieser freigelegten Fläche umfasst, indem sie einem Bad ausgesetzt wird, in dem Ultraschall mit einer Frequenz zwischen 10 kHz und 80 kHz unter Bedingungen angelegt wird, die geeignet sind, die Kavitation längst der Fläche auszulösen, die nach dem Bruch vorhandene, nicht übertragene Restregionen beseitigt, ohne den Rest der freigelegten Fläche zu verschlechtern.

2. Verfahren nach Anspruch 1, **dadurch gekennzeichnet, dass** die geschwächte vergrabene Schicht durch Implantation von Wasserstoffionen mit einer Dosis zwischen 10¹⁶ Ionen.cm⁻² und 5.10¹⁷ Ionen.cm⁻² gebildet wird.

3. Verfahren nach Anspruch 1 oder Anspruch 2, **dadurch gekennzeichnet, dass** der Ultraschall unter folgenden Bedingungen angewandt wird:
- Ultraschallleistung/Badvolumen >5 W/l
- Leistung > 10 W
- Dauer > 1 min
- Temperatur zwischen 1 °C und 100 °C

4. Verfahren nach einem der Ansprüche 1 bis 3, **dadurch gekennzeichnet, dass** das Bad im Wesentlichen aus Wasser gebildet ist.

5. Verfahren nach einem der Ansprüche 1 bis 4, **dadurch gekennzeichnet, dass** die Badflüssigkeit eine Mischung aus Wasser und Azeton ist.

6. Verfahren nach einem der Ansprüche 1 bis 5, **dadurch gekennzeichnet, dass** die Ultraschallfrequenz zwischen 10 kHz und 40 kHz mit einer Leistung zwischen 5 W/l und 60 W/l gewählt wird, und die Dauer der Ultraschallbehandlung zwischen 1 min und 20 h liegt.

7. Verfahren nach einem der Ansprüche 1 bis 6, **dadurch gekennzeichnet, dass** das Aussetzen in einem Bad, in dem Ultraschall unter Bedingungen angelegt wird, die geeignet sind, die Kavitation längs der Fläche auszulösen, ohne Zwischenbehandlung der Oberfläche nach dem Bruchschritt realisiert wird.

8. Verfahren nach einem der Ansprüche 1 bis 7, **dadurch gekennzeichnet, dass** nach dem Schritt des Aussetzens in einem Bad, in dem der Ultraschall angelegt wird, ein Recycling des Donorsubstrates ohne Zwischenbehandlung erfolgt.

9. Verfahren nach einem der Ansprüche 1 bis 8, **dadurch gekennzeichnet, dass** der Schritt des Aussetzens in einem Bad, in dem der Ultraschall unter Bedingungen angelegt wird, die geeignet sind, die Kavitation auszulösen, kollektiv auf die jeweiligen Flächen mehrerer Substrate, die durch einen solchen Bruchschritt freigelegt wurden, angewandt wird.

10. Verfahren nach einem der Ansprüche 1 bis 9, **dadurch gekennzeichnet, dass** das Donorsubstrat aus Silizium besteht.

## Claims

1. Method for forming a plurality of thin layers from a microtechnological donor substrate, according to which cycles comprising the following steps are carried out:
* a buried weakened layer is formed by ion implantation below a free face of this donor substrate, the material thickness contained between this free face defining the thickness of a future thin layer,
* this donor substrate is placed in intimate contact with a handle substrate by molecular adhesion between this free face of the donor substrate and a free face of this handle substrate,
* a fracture is induced along this buried weakened layer so as to release said thin layer from a remainder of the donor substrate, while exposing respective faces of this thin layer and this remainder,
* a treatment is applied to said exposed face of the remainder of the donor substrate with a view to a new cycle for which this remainder constitutes the donor substrate,
said treatment of said exposed face comprising planarizing this exposed face by placing it in a bath in which ultrasound with a frequency of between 10 kHz and 80 kHz is applied under conditions suitable for causing cavitation along said face which removes residual non-transferred zones that remain after fracturing without damaging the rest of the exposed face.

2. Method according to claim 1, **characterized in that** the buried weakened layer is formed by hydrogen ion implantation, with a dose of between 10¹⁶ ions.cm⁻² and 5.10¹⁷ ions.cm⁻².

3. Method according to claim 1 or claim 2, **characterized in that** the ultrasound is applied under the following conditions:
- ultrasound power/volume of the bath > 5 W/I
- power > 10 W
- duration > 1 min
- temperature between 1°C and 100°C.

4. Method according to any one of claims 1 to 3, **characterized in that** the bath is essentially formed by water.

5. Method according to any one of claims 1 to 4, **characterized in that** the fluid of the bath is a mixture of water and acetone.

6. Method according to any one of claims 1 to 5, **characterized in that** the frequency of the ultrasound is selected between 10 kHz and 40 kHz with a power of between 5 W/l and 60 W/l, and the duration of the ultrasound treatment is between 1 min and 20 h.

7. Method according to any one of claims 1 to 6, **characterized in that** the step of placement in a bath in which ultrasound is applied under conditions suitable for causing cavitation along said face is carried out without an intermediate surface treatment after the fracture step.

8. Method according to any one of claims 1 to 7, **characterized in that** recycling of the donor substrate without an intermediate treatment is carried out after the step of placement in a bath in which said ultrasound is applied.

9. Method according to any one of claims 1 to 8, **characterized in that** the step of placement in a bath in which ultrasound is applied under conditions suitable for causing cavitation is carried out collectively for the respective faces of a plurality of substrates exposed by such a fracture step.

10. Method according to any one of claims 1 to 9, **characterized in that** the donor substrate is made of silicon.
